# EUROPEAN PATENT SPECIFICATION

(11) **EP 1 536 523 B1**
(45) Date of publication and mention of the grant of the patent: **16.07.2008**
(21) Application number: 05004457.7
(22) Date of filing: 12.11.1997
(51) Int. Cl.: H01R 12/04

(54) **High density connector having a ball type of contact surface**
Verbinder hoher Packungsdichte mit Kontaktoberflächen vom Kugeltyp
Connecteur à haute densité à surface de contact du type a bille

(30) Priority: 14.11.1996 US 30799; 02.05.1997 US 851165
(43) Date of publication of application: 01.06.2005
(62) Divisional of application: 97119827.0
(73) Proprietor: FCI, 78000 Versailles (FR)
(72) Inventor: Olson, Stanley W., East Berlin Pennsylvania 17316 (US)
(74) Representative: Hess, Peter K. G.

(56) References cited:
- GB-A- 2 293 502
- US-A- 3 148 310
- US-A- 5 419 710
- US-A- 5 518 410
- PATENT ABSTRACTS OF JAPAN vol. 018, no. 551 (E-1619), 20 October 1994 (1994-10-20) & JP 06 203896 A (FUNAI ELECTRIC CO LTD), 22 July 1994 (1994-07-22)

## Description

### BACKGROUND OF INVENTION

### 1. Field of the Invention

The present invention relates to electrical connectors and more particularly to high density I/O connectors such as connectors that are attachable to a circuit substrate by use of a solder ball contact surface.

### 2. Brief Description of Prior Developments

The drive to reduce the size of electronic equipment, particularly personal portable devices, and to add additional functions to such equipment has resulted in an ongoing drive for miniaturization of all components, especially electrical connectors. Efforts to miniaturize electrical connectors have included reductions in the pitch between terminals in single or double row linear connectors, so that a relatively high number of I/O or other lines can be interconnected by connectors that fit within the tightly circumscribed areas on circuit substrates that are allotted for receiving connectors. The drive for miniaturization has also been accompanied by a shift in manufacturing preference to surface mount techniques (SMT) for mounting components on circuit substrates. The confluence of the increasing use of SMT and the required fine pitch of linear connectors has resulted in approaching the high volume, low cost limits of SMT for mounting connectors that employ presently available mounting designs. The limit is being reached because further reductions in pitch of the terminals greatly increase the risk of bridging adjacent solder pads or terminals during reflow of the solder paste. Array electrical connectors have been proposed to satisfy the need for increased I/O density. Such electrical connectors have a two dimensional array of terminal tails and can provide improved density. However, these connectors present certain difficulties with respect to attachment to the circuit substrate by SMT techniques because the surface mount tails of most, if not all, of the terminals must be attached beneath the connector body. As a result, the mounting techniques used must be highly reliable because of the difficulty in visually inspecting the solder connections and repairing them, if faulty.

Mounting techniques for other electronic components have addressed the reliability of solder connections in hard to inspect positions. For example, integrated circuit (IC) mounting to plastic or ceramic substrates have increasingly employed solder balls and other similar packages to provide such a reliable attachment. In a solder ball technique, spherical solder balls attached to the IC package are positioned on electrical contact pads of a circuit substrate to which a layer of solder paste has been applied, typically by use of a screen or mask. The unit is then heated to a temperature at which the solder paste and at least a portion of the solder ball melt and fuse to an underlying conductive pad formed on the circuit substrate. This heating process is commonly referred to as solder reflow. The IC is thereby connected to the substrate without need of external leads on the IC.

While the use of solder balls and similar systems in connecting ICs to a substrate has many advantages, a corresponding means for mounting an electrical connector or similar component on a circuit substrate has recently become desirable. The use of such techniques in mounting electrical connectors has lagged the use in mounting ICs because the use of solder ball technologies in mounting an electrical connector or similar component to a circuit substrate presents complexities not encountered with IC mounting. For example, ICs that have employed solder balls generally present a flat attachment surface. By contrast, connectors usually do not present a flat attachment surface but rather present a series of elongated conductors, commonly referred to as terminal tail ends. Attachment of a solder ball to the small end surface presented by the tip of a terminal tail end presents manufacturing difficulties not present in the attachment of solder balls to a flat surface.

In addition to the manufacturing difficulties, connectors are generally more susceptible to solder joint stress due to the effects of differential Coefficients of Thermal Expansion (CTE) between the connector and the circuit substrate. This susceptibility is primarily due to size and geometry differences between a connector and an IC. For example, IC mounting surfaces are generally on the order of 2.5 centimeters square. Connector mounting surfaces, on the other hand, generally have a narrow width (e.g., 0.5 centimeters or less) and a much longer length (e.g. 5.0 centimeters or more). Primarily because of the relatively long length of the connector, differences in CTE between a connector and a circuit substrate potentially have a much greater effect on the solder joints than the differences in CTE between an IC and a circuit substrate.

Connectors attached to circuit substrates via solder ball techniques are also more susceptible to joint stress than a conventional SMT attachment technique. For example, a conventional SMT attaches connector terminal tails to a circuit substrate horizontally, providing more attachment surface area for the solder joint. The additional surface area of the solder joint in the conventional SMT technique is stronger and, consequently, more tolerant of differences in CTE between the connector, terminal tails and circuit substrate. A solder ball connection, on the other hand, attaches a connector terminal tail vertically to the circuit substrate with the end of the terminal tail directly mated to the circuit substrate, reducing the amount of attachment surface area. As a result of the smaller attachment surface, differences in CTE are much more likely to stress the terminal tall to circuit substrate joint resulting in failure or quality problems.

Furthermore, in most circuit substrate applications, the electrical component mounting surfaces of the surface mount connections must meet strict coplanarity requirements. Thus, the use of solder balls to attach a connector to a circuit substrate imposes the requirement that the solder balls are coplanar in order to ensure a substantially flat mounting interface. Thus, in the final application the balls will reflow and solder evenly to a planar circuit substrate. Any significant differences in solder coplanarity on a given mounting connection can cause poor soldering performance when the connector is reflowed onto a printed circuit board. Accordingly, users specify very tight coplanarity requirements to achieve high soldering reliability, on the order of 0.1 to 0.2 mm for example. By providing a connection using a solder ball technique, the coplanarity requirements can be met and sometimes exceeded. Unlike conventional SMT, the solder ball can absorb variations in terminal tail length by changing shape upon the application of heat to bridge the gaps between the terminal tail ends and the circuit substrate connections.

The present invention recognizes that there is a need for an improved electrical connector apparatus and accompanying electrical connector construction techniques that address the shortcomings of present electrical connectors.

### SUMMARY OF INVENTION

The invention meets the above needs by providing an improved electrical connector for use in forming an electrical connection between a contact portion of an electrical component and a contact portion of a circuit substrate and method for constructing the electrical connector. The electrical connector comprises a connector body, a plurality of electrical contacts disposed on the connector body and arranged to electrically mate with the contact portion of the electrical component, a plurality of electrical elongated conductors, alternately referred to as terminal tails, disposed on the connector body and arranged to form an electrical connection with the circuit substrate. The elongated conductors are in electrical communication with corresponding electrical contacts.A substrate contact, such as a solder ball, is connected via a butt joint on an end of each of the elongated conductors such that an electrical connection between the elongated conductors and the contact portion of the circuit substrate is selectively accommodated.

Each of the elongated conductors is disposed in a spacer member passage that has a cross-sectional diameter a little larger than the cross-sectional diameter of the elongated conductor. As a result, clearance is provided between the sides of the electrical conductor and the side walls of the passage. Preferably, the cross-section is substantially rectangular in shape. The passages terminate in wells that are disposed across a planar face of the spacer. The wells have a rectangular top opening that is longer along a length of the spacer. Moreover, a portion of the spacer proximate the elongated connector tail end is coated with an anti-migration solution such as oleophobic-hydrophobic flourochemical polymer to assist the process of solder ball formation and attachment.

One of the primary manufacturing challenges in manufacturing the above described connector involves the method of fusing substrate contact material (e.g., a solder ball) to the end of the tail portion of the elongated conductors. The invention accomplishes this attachment task by first forming a well, as described above, within a planar surface of the conductor. Here, the planar surface is provided by a spacer member that can be formed separately and attached to the body of the connector or alternatively formed as an integral component with the body. In either case, the tail ends of the elongated conductors are inserted into passages formed in the spacer member such that the tail ends terminate within a predefined range of the mounting surface and are exposed within the well. The well is then filled with solder paste. Finally, the substrate contacts are fused to the ends of the elongated conductors according to two embodiments.

In the first embodiment, a pre-manufactured substrate contact member such as a solder ball is seated into the paste. The tail end of the elongated connector, the solder ball (substrate contact member), and solder paste are then heated to a predefined temperature above the melting point of the paste such that the molten solder paste coalesces around the solder board and fuses the solder ball to the elongated conductor end.

According to a second embodiment, no pre-manufactured substrate contact member is used. Rather, a pre-specified amount of solder paste is applied to and over the well. Thereafter, the tail end and solder paste are heated to a predefined temperature, above the melting point of the solder paste. As a result, the solder paste coalesces into a spherical body attached to the end of the elongated conductor and clear of the well.

The process for forming a substrate contact on an elongated conductor as described above is further enhanced by coating the well with an anti-migration solution such as oleophobic-hydrophobic fluoropolymer. Thereafter, when the solder paste is heated, the paste is repelled from the treated surfaces of the well and spacer member. This results in a more uniform ball formation. The substrate contact attachment process can be further enhanced by passivating a portion of the tail end such that solder paste will not attach to the passivated portion. As a result, the solder can attach only to the very end of the elongated conductor. Solder flow restriction at the tail end can be enhanced by passivating the tail end, coating the tail end with an anti-migration solution or both.

### BRIEF DESCRIPTION OF DRAWINGS

The method and connector of the present invention is further described with reference to the accompanying drawings in which:
- FIG. 1: is a top plan view of a card edge connector which represents a preferred embodiment of the connector of the present invention;
- FIG. 2: is a front view of the card edge connector shown in FIG. 1;
- FIG. 3: is a side view of the card edge connector shown in FIG. 1;
- FIG. 4: is a cross-sectional view through 4-4 in FIG. 1;
- FIG. 5: is a detailed view of the substrate contact area of FIG. 4;
- FIG. 6: is a schematic cross-sectional view of completed substrate contact connection to a first tail end embodiment;
- FIG. 7: is a schematic cross-sectional view of a completed substrate contact connection to a first tail end embodiment;
- FIG. 8: is a bottom plan view of a substrate contact connection;
- FIG. 9: is a schematic cross-sectional view of a substrate contact connection according to a first method;
- FIG.10: is a schematic cross-sectional view of a substrate contact connection according to a second method; and
- FIG.11: is a graph comparing relative terminal tail height versus substrate contact height.

### DETAILED DESCRPITION OF PREFERRED EMBODIMENTS

According to presently preferred embodiments, a linear connector having a solder ball type electrical contact surface and methods for attaching the solder balls to the connector will now be described with reference to the Figures. It will be appreciated by those of ordinary skill in the art that the description given herein with respect to those Figures is for exemplary purposes only and is not intended in any way to limit the scope of the invention. For example, an electrical connector is described herein having a substantially rectangular mounting surface wherein the length of the mounting surface is substantially greater than its width. However, the particular dimensions described herein with reference to that connector are merely for the purpose of illustration and are not intended to be limiting. The concepts disclosed herein have a broader application to a much wider variation of connector mounting surface geometries. The concepts disclosed with reference to this connector could be employed, for example, with a connector having a connection mounting surface having a more square or radial geometry.

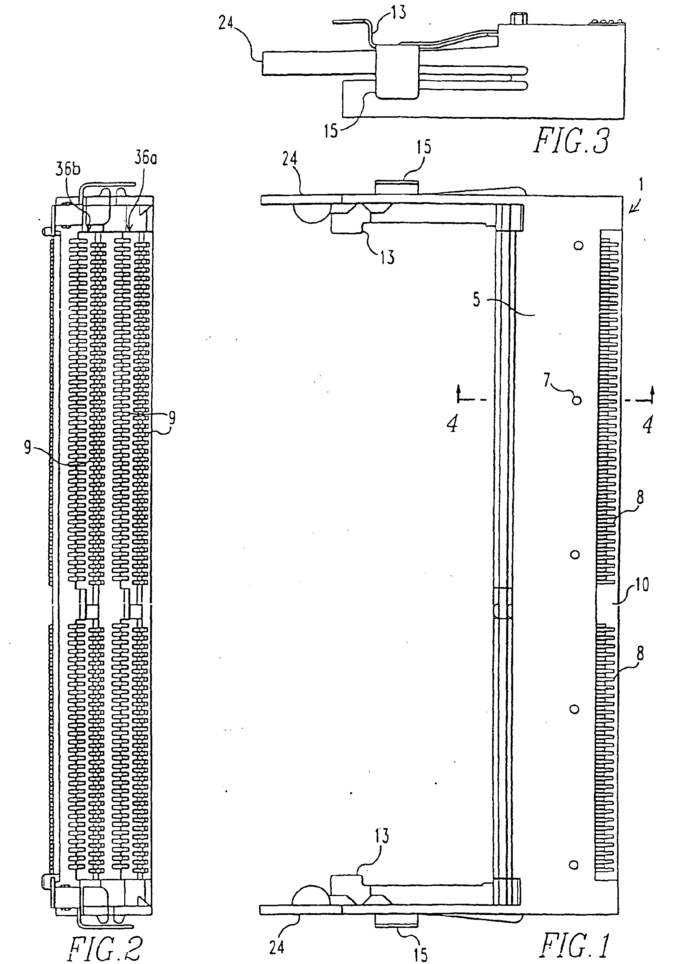

Referring now to Figures 1-3, there is shown top, front and side views, respectively, of an electrical connector 1 of the present invention. As shown, connector 1 comprises a connector body 5, a plurality of elongated conductors 8, an interface or spacer member 10, electrical element contacts 9, hold down element 13 with an upwardly extending arm 15 and connector latches 24. As best shown in Figure 2, the front of connector 1 comprises a plurality of electrical contacts 9 arranged within two openings, which are designed to selectively engage and mate with corresponding electrical contacts for an electrical element such as those electrical contacts present on a daughter board. As is described in further detail below, each electrical contact 9 is in electrical communication with a corresponding elongated conductor 8 such that a current flow path is established therebetween. Elongated conductors 8 are designed for permanent connection to electrical contacts on a circuit substrate (not shown). Thereafter, electrical communication can be selectively established between an electrical element inserted into electrical connector 1 and a circuit substrate to which it is attached. In this way, for example, electrical connector 1 can be connected to a circuit substrate such as a card edge connector of the type used in a computer motherboard. Thereafter, a user, via attached electrical connector 1, can selectively add a daughter board or boards (e.g., memory modules) to the computer motherboard.

The electrical contacts 9 of connector 1 comprise a linear array stacked in two parallel rows 36A and 36B, each row accepting a single daughter board. A user inserts an electrical element laterally into connector 1. As each daughter board is inserted, connector latches 24 that correspond to the particular row, 36A or 36B, engage and lock the electrical element into place on connector 1. Although two parallel rows are shown with respect to connector 1, the concepts disclosed herein are equally applicable to a connector having one row, three rows and so on. Preferably, connector body 5 and connector latches 24 are constructed from a molded plastic material to reduce weight.

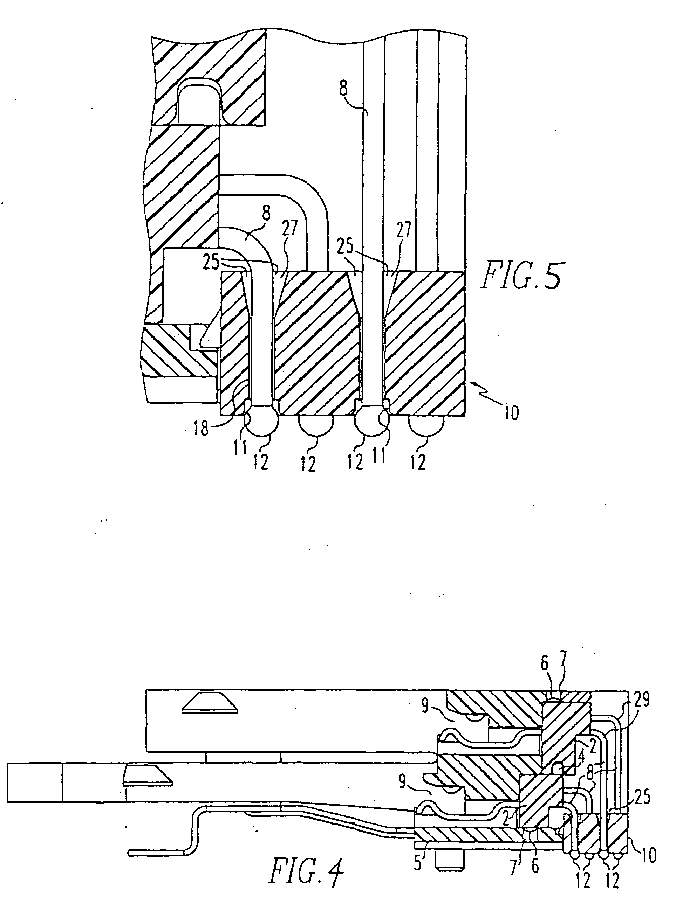

Further details of the arrangement of connector 1 can be seen with reference to Figure 4. Figure 4 presents a cross-sectional view of connector 1 taken along the line 4-4. As shown therein, connector 1 further comprises stacked insert molded wafers 2, which are locked together in a pin and socket arrangement 4. Thus locked together; wafers 2 are retained in housing 5 by a series of dimples 6 which are fitted into cylindrical openings 7. A plurality of elongated conductors 8 extend into each of wafers 2. Each elongated conductor therein joins in electrical communication with a corresponding electrical contact 9. Each elongated conductor 8 also extends out from wafer 2 and into spacer member 10. A bend 29, preferably about 90 degrees in the disclosed embodiment, along with the length of elongated conductor 8 allows connector 1 to provide interfaces on two different planes.For example, the bend allows connector 1 to interface vertically with respect to the board, while interfacing with an electrical element that is positioned horizontally with respect to the board. As such, the electrical element projects horizontally over the circuit substrate surface conserving circuit substrate height. Other degrees of bends 29 could be used as required to adjust to a variety of application geometries without departing from the inventive aspects of the present invention. For example, the elongated conductors could have no bend, in which case, the electrical element would project vertically with respect to the circuit substrate. The tail end of each elongated conductor 8 extends through a corresponding passage 25 in spacer member 10 and is terminated by a substrate contact 12 such as a solder ball. Each elongated conductor 8 preferably has a substantially rectangular cross-sectional shape such as a square; however, other cross-sectional shapes such as round may function equally as well.

Figure 5 presents a more detailed view of elongated conductors 8 in relation to spacer member 10. Spacer member 10 can be a separate component that is attached to connector body 5 or, alternatively, could be integrally formed therewith. As shown, spacer member 10 has a plurality of passages 25, one passage 25 being provided to guide and support one tail end of each elongated conductor 8 disposed within a passage 25. Significantly, the diameter of passage 25 is a little larger than the diameter of elongated conductor 8. Accordingly, the tail end of elongated conductor 8 is disposed within passage 25 such that clearance 18 is provided between the sides of elongated conductor 8 and the walls of passage 25. For example, whereas elongated conductor 8 has a width of about 0.305 mm, passage 25 has a width of about 0.38 mm. Clearance 18 provides an important feature in tolerating differences in Coefficients of Thermal Expansion (CTE) between the material forming the spacer member 10 and the material forming the circuit substrate on which the connector is mounted. That is, passages 25 are sized to provide guidance to elongated conductors 8 during substrate contact 12 attachment and further during connector 1 attachment to a circuit substrate. However, elongated conductors 8 have a clearance with and are not physically connected to spacer member 10, permitting spacer member 10 to expand and contract without the side walls of the passages 25 impinging upon elongated conductors 8 because of the clearance. The amount of clearance is related to the differential in CTE noted above. As a result, stress is reduced in a solder joint between elongated conductors 8 and the circuit substrate during thermal expansion and contraction cycles. Passage 25 preferably comprises a cross-section substantially similar to the cross-section of elongated conductor 8. For example, if elongated conductor 8 has a substantially rectangular cross-section then passage 25 also has a substantially rectangular cross-section. Each passage 25 terminates in the bottom of well 11 and includes a wide inlet cavity 27 that provides guidance to elongated conductor 8 during insertion into spacer member 10. Each end of a conductor 8 terminates within well 11 and therein is fused to a substrate contact 12, which is also partially disposed within well 11.For a variety of reasons, including the bend in elongated conductors 8, the termination height of the elongated conductors 8 within wells 11 will vary among conductors 8. This height variation is commonly referred to as coplanarity.

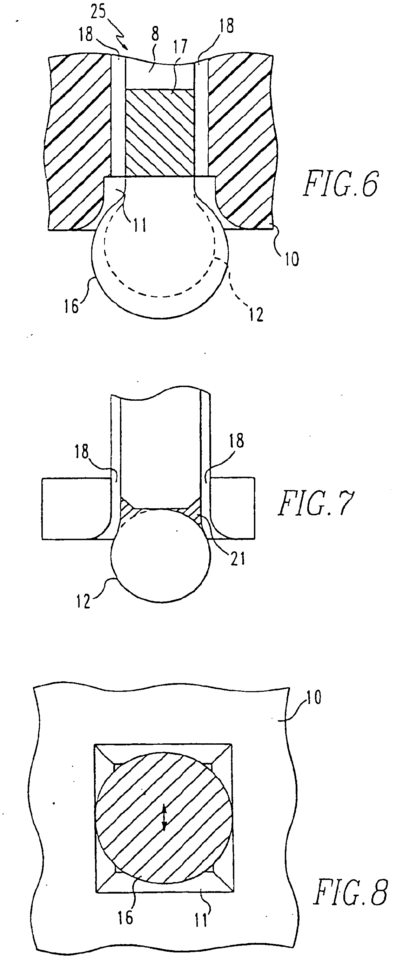

Referring now to Figure 8, a bottom plan view of a substrate contact 12 in relation to well 11 is depicted. As shown, well 11 is substantially rectangular in cross-section having a length 1 slightly larger than a width w. For example, width w is preferably 0.5 mm; whereas, length 1 is preferably 0.55 mm. Additionally, according to a first embodiment, substrate contact 12 is on the order of .3 mm to .5 mm. Thus, there is a clearance of at least about 0.05 mm between substrate contact 12 and two sides of well 11. As with passages 25, the rectangular shape of well 11 also accommodates effects of thermal expansion and contraction. The clearance between the sides of well 11 and substrate contact 12 ensures that well 11 will not impinge upon the solder joint during expansion and contraction.

The length of well 11 is aligned with the length of spacer member 10 to accommodate thermal cycles while maximizing conductor 8 density. Because spacer member 10 is longer along its length than its width, the effects of expansion and contraction will be correspondingly greater along the length of spacer member 10 than along the width. Accordingly, a top opening of well 11 has dimensions that accommodate the lengthwise thermal expansion and contraction. Along the width of spacer member 10, the effects of expansion and contraction are less of an issue because of the smaller size relative to the length. Consequently, the width of well 11 can be narrower than the length. The overall result is a well 11 that is sized to accommodate expansion and contraction along the length of connector 1 while allowing a higher density of wells 11 and conductors 8 along the width of connector 1.Additionally, because the top opening of well 11 is dimensioned in this way, tighter elongated conductor 8 densities across the width of spacer member 10 are possible while allowing well 11 to maintain a required volume of solder paste during substrate contact attachment.

Further details of the connection of substrate contacts 12 to elongated connectors 8 will now be described with reference to Figures 6-9. Referring now to Figure 6, an embodiment of the attachment of substrate contact 12 to end of the elongated conductor 8 is shown. The substrate contact 12 is fused to the end of elongated conductor 8 with a butt joint. To ensure a quality butt joint between substrate contact 12 and elongated conductor 8, a portion of the tail end of each elongated conductor 8 has a passivated surface 17. Passivated surface 17 ensures that molten solder, used during the attachment process, does not wick along the sides of elongated conductor 8 and potentially enter clearance 18 during substrate contact reflow. As described above, clearance 18 accommodates differences in Coefficients of Thermal Expansion. Accordingly, if solder enters clearance 18, the reliability of a corresponding solder joint is jeopardized as spacer member 10 expands and contracts. Therefore, an anti-solder wicking or non-solder wettable material is applied to the surface 17. One preferred material for this purpose is nickel plating. While not intending to be bound by any particular theory, it is believed that the solder resistant feature of this nickel plated area results from or is enhanced by the oxidation of the nickel plating, for example, by laser oxidation, steam exposure or ambient air exposure. Other solder wick resistant materials are believed to be useable for this purpose, such as fluorine containing solder resist coatings. Alternatively, a combination of nickel and fluorine could be used.

Other embodiments are possible to prevent solder wicking. For example, Figure 7 depicts a second embodiment of the substrate contact and elongated conductor 8 interface. In this embodiment, the end of elongated conductor 8 is beveled. As a result of the bevel, solder filet 21 is formed between substrate contact 12 and the end of elongated conductor 8 during the attachment of substrate contact 12 to elongated conductor 8. This second embodiment also reduces the potential for solder to wick into the clearance 18 by capturing solder within a bevel.

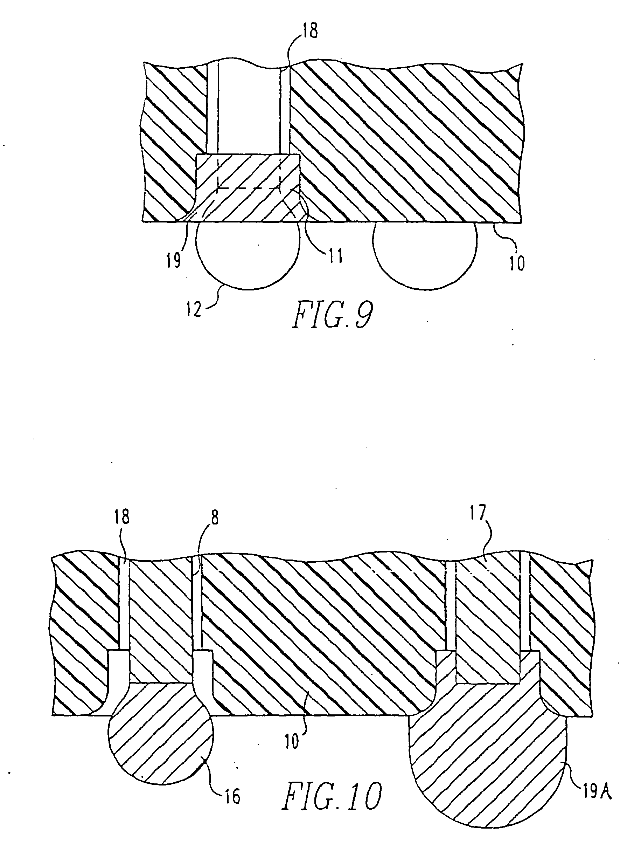

In the embodiments previously described, the tail end of each elongated conductor 8 is positioned in a well 11. Each well 11 is substantially uniform in size and shape and provides several features of importance with respect to the present invention. Referring to Figure 9, for example, each well 11 ensures that a generally uniform amount of solder paste 19 is received therein using a process such as a simple deposit and squeegee operation. Thus, the amount of solder available for securing each solder ball (substrate contact 12) onto an end of elongated conductor 8 is substantially uniform. The wells 11 locate the position of each substrate contact in the lateral X-Y directions prior to attachment of the substrate contacts in the Z direction with respect to the bottom surface of spacer member 10 and the end of elongated conductor 8.After solder reflow, as best shown in Figure 6, the solder contained in paste 19 in well 11 increases the solder ball (substrate contact 12) size by area 16.

The size of area 16 is affected by the height of the tip of conductor 8 within well 11. The amount of solder paste 19 deposited in each well 11 is altered by the variation in elongated conductor 8 height. For example, a conductor 8 tip that is higher in well 11 will displace more solder paste; whereas, a conductor 8 tip that is lower in well 11 will displace less solder paste. If less paste is available in the well, during reflow of the solder paste less paste is available to coalesce around the substrate contact, resulting in a slightly smaller substrate contact 12. A smaller substrate contact will result in a lower contact height. On the other hand, when more paste is available in the well a larger substrate contact will result, corresponding to a higher substrate contact height.

The process above describes a substrate contact attachment via the use of preformed substrate contacts 12 such as solder balls. However, according to a second embodiment, the substrate contact interface can be formed without the use of preformed substrate contacts. Referring now to Figure 10 there is shown a method of substrate contact 12 attachment using only solder paste. According to this method, a pre-specified amount of solder paste 19A is deposited in and over well 11. This pre-specified amount of solder paste can be deposited by a commercial dispensing machine such as a CAM/A LOT 1818 available from Camelot Systems, Inc. After the solder paste deposition, the connector is heated above the solder paste melting point. The solder within the paste then coalesces into a substrate contact 16A, which forms on the end of elongated conductor 8.As described above with reference to the preformed substrate contact technique, the variable volume of paste in the well 11 will effect the size and coplanarity of the resultant substrate contacts. Similar to the preformed substrate contact method, the displacement of solder paste by the height of conductor 8 within well 11 will affect the final coplanarity in this method as well.

As previously mentioned, coplanarity of the substrate mounting face of a connector utilizing substrate contact mounting is critical with any SMT device. In connector 1, there are two primary factors that influence the coplanarity of the connector to circuit substrate interface: (1) the coplanarity of the end surfaces, i.e., the tips, of elongated conductors 8; and (2) the coplanarity of substrate contacts 12. The coplanarity of the tips of elongated conductors 8 is affected by a variety of factors such as length of the conductor 8, uniformity of the bends, the ability to keep the conductors consistently parallel and the like. As a result, it is extremely difficult to maintain the conductor tips within the final coplanarity requirement of the circuit substrate manufacturers while maintaining high yields and low costs.As described more fully below, however, through the use of the substrate contact attachment in connection with well 11, the restrictive coplanarity requirements for the completed connector 1 is met while imposing a less restrictive coplanarity requirement on the tips of elongated conductors 8.

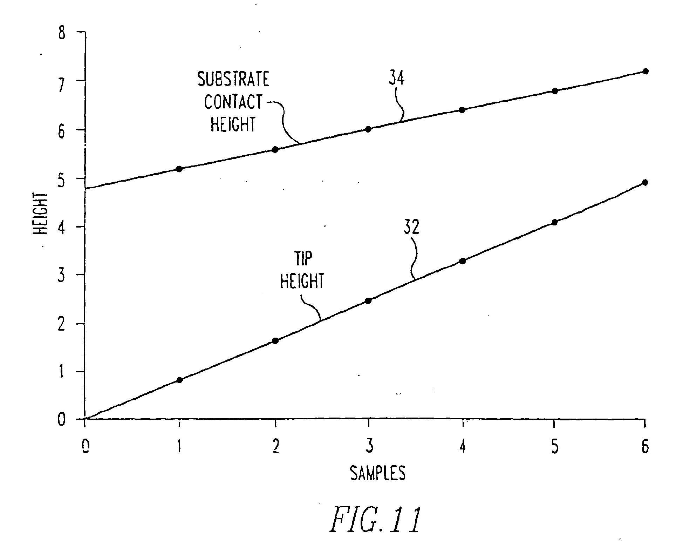

Referring to Figure 11, there is shown an exemplary graph of the coplanarity of the tips of elongated conductors 8 before the attachment of substrate contacts 12 (curve 32) versus the coplanarity of elongated conductors 8 with the attached substrate contacts 12 (curve 34). The units along the abscissa represents different samples used in the coplanarity measurement. The units along the ordinate represent unit sample height labeled 0, 1, 2 and so on; however, these units are labeled to merely illustrate the relative relationship between the tip position and corresponding substrate contact height. Actual units and values will vary depending on factors such as well dimensions and substrate contact size.

Curve 32 represents the height of an elongated conductor tip as measured above the bottom of well 11 (see also Figure 6). Thus, at sample 0, for example, the measured tip height is 0 units. At sample 1, the tip height is about 0.75 and so on. At sample 5, the tip height is about 4 units.

Curve 34 represents the height above the bottom of well 11 of the same tip after attachment of the substrate contact 12 (see also Figure 6). For sample 0, the corresponding height after attachment of substrate contact 12 is about 4.5 units. At sample 1, the corresponding substrate contact height is about 5 units and so on. Finally, for sample 5, the substrate contact height is about than 6.5 units.

Comparing the curves 32 and 34 illustrates that the process of attaching substrate contact 12 to the end of conductor 8 absorbs some of the variations in coplanarity of the tips of conductors 8. For example, in sample 0, the difference between the tip height (preattachment curve 32) and the substrate contact height (post attachment curve 34) is about 4.5 units. By contrast, at sample 5, the tip height is about 4 units, whereas the substrate contact height is about 6.5 units, for a difference of only 2.5 unit. Moreover, the total change in tip height over the entire range of samples was about 4 units, but the total change of substrate contact height over the same sample range was only about 2 units.

To further illustrate the coplanarity regulation performed by the wells consider the following example. A typical connector before substrate contact attachment will have a number of elongated conductors 8 with different tip heights. If, for example, one conductor 8 has a tip height of 0 (i.e., the tip is exactly flush with the bottom of the well) and another connector has a tip height of 4 units, the coplanarity between the tips would be about 4 units. Under some circumstances this coplanarity variation of 4 units may be unacceptable. However, after the attachment of substrate contacts 12 according to the methods described herein, the corresponding substrate contact heights will be 4.5 units and 6.5 units respectively, for a final coplanarity of about 2 units. Significantly, the final coplanarity is only 2 units versus 4 units.

In summary, the coplanarity differences of the tips of elongated conductor 8 is counteracted during the attachment of substrate contacts 12. Substrate contact size is transformed by the variable volume of solder paste placed in well 11 as a result of variations in heights of elongated conductor tips. Consequently, the overall height of the substrate contact after attachment to the tip of conductors 8 is somewhat equalized. Accordingly, a connector 1 can be constructed with a higher tolerance for elongated conductors coplanarity than would be possible otherwise.

According to another aspect of the invention, the quality of substrate contact 12 attachment is enhanced by the application of an anti-migration or anti-wicking solution to an area in and around well 11. Without the anti-migration solution, substrate contacts may form unevenly, sometimes wicking to the well edges. With the anti-migrations solution applied, solder is repelled from the well edges and forms more uniform substrate contacts on the ends of elongated conductors 8. The preferred anti-migration solution is oleophobic-hydrophobic fluoropolymer. Such a solution is commercial available from 3M corporation under the Fluorad brand name.

In the method of this invention, the substrate contact will preferably be a solder ball. Those skilled in the art: however, will appreciate that it may be possible to substitute other fusible materials which have a melting temperature less than the melting temperature of conductor body 5 and elongated conductors 8. The fusible element can also have a shape other than a sphere. The ends of elongated conductors 8 will extend into well 11 by a sufficient amount to present adequate surface area for the substrate contact to fuse to, and will usually preferably extend into the well from about 25 percent to 75 percent and more preferably to about 50 percent of the depth of the well as previously mentioned. The well ordinarily will be circular, square or the shape of any other regular polygon in cross-section. When the conductive element is solder, it will preferably be an alloy which is in the range of about 10% Sn and 90% Pb to about 90% Sn and 10% Pb. More preferably the alloy will be eutectic which is 63% Sn and 37% Pb and has a melting point of 183 degrees C. Typically, a "hard" solder alloy with a higher lead content would be used for mating to materials such as ceramics. The "hard" substrate contact will "mushroom" or deform slightly as it softens under typical SMT conditions, but will not melt. A "soft" eutectic ball is used for attachment to printed circuit boards and will usually reflow and reform itself under typical SMT conditions. Other solders known to be suitable for electronic purposes are also believed to be acceptable for use in this method. Such solders include, without limitation, electronically acceptable tin-antimony, tin-silver and lead silver alloys and indium. Before the substrate contact or other conductive element is positioned in a well, that well would usually be filled with solder paste.

Alternatively, in place of the substrate contact previously described, a body of material which is not fusible at SMT temperatures may be attached by reflow of the solder paste in the well onto the contacts. The connector mounting interface would comprise a plurality of infusible spheres in a tightly coplanar array. Such a connector would be secured on a substrate by conventional SMT techniques.

While it is believed that a solder paste or cream incorporating any conventional organic or inorganic solder flux may be adapted for use in this method, a no clean solder paste or cream is preferred. Such solder pastes or creams would include a solder alloy in the form of a fine powder suspended in a suitable fluxing material.

This powder will ordinarily be an alloy and not a mixture of constituents. The ratio of solder to flux will ordinarily be high and in the range of 80% - 95% by weight solder or approximately 50% by volume. A solder cream will be formed when the solder material is suspended in a rosin flux. Preferably the rosin flux will be a white rosin or a low activity rosin flux, although for various purposes activated or superactivated rosins may be used. A solder paste will be formed when a solder alloy in the form of a fine powder is suspended in an organic acid flux or an inorganic acid flux. Such organic acids may be selected from lactic, oleic, stearic, phthalic, citric or other similar acids. Such inorganic acids may be selected from hydrochloric, hydrofluoric and orthophosphoric acid. Cream or paste may be applied by brushing, screening, or extruding onto the surface which may advantageously have been gradually preheated to ensure good wetting.

Heating is preferably conducted in a panel infra red (IR) solder reflow conveyor oven. The connector would then be heated to a temperature above the melting point of the solder within the solder paste

While the present invention has been described in connection with the preferred embodiments of the various figures, it is to be understood that other similar embodiments may be used or modifications and additions may be made to the described embodiment for performing the same function of the present invention without deviating therefrom. Therefore, the present invention should not be limited to any single embodiment, but rather construed in breadth and scope in accordance with the recitation of the appended claims.

## Claims

1. An electrical connector (1) comprising:
a) a conductor (8) positioned on a first dielectric body (5), wherein the conductor (8) defines a tail portion;
b) a second dielectric body (10) positioned adjacent to said first dielectric body (5), wherein said second dielectric body (10) defines a passage (25) that receives said tail portion of said conductor (8); and
c) a fusible element (12) attached **only on an end surface** of said tail portion of said conductor (8) **by a butt joint**, wherein said second dielectric body (10) is positioned between said first dielectric body (5) and said fusible element (12).

2. The electrical connector as claimed in claim 1, for use in forming an electrical connection between a first electrical element having an electrical contact portion and a second electrical element having an electrical contact portion, the electrical connector comprising:
a) a connector body (5) constituting said first dielectric body (5);
b) a first electrical contact (9) disposed within said first dielectric body (5), said first electrical contact (9) comprising an electrically conductive surface for mating with the electrical contact portion of the first electrical element so as to form an electrical connection between said fist electrical contact (9) and the first electrical element;
c) an interface member (10) constituting said second dielectric body (10) and comprising a well (11) disposed within an interface surface of said interface member (10), said passage (25) connecting said well (11) with a second surface of said interface member (10);
d) a second electrical contact (12) constituting said fusible element (12) and comprising a shaped body of an electrically conductive material having an outer surface for joining said electrical connector (1) with the electrical contact portion of the second electrical element; wherein
e) said conductor (8) being elongated in a longitudinal direction and being electrically connected between said first electrical contact (9) and said second electrical contact (12), said connector body (5) and said interface member (10) being separated along a length of said elongated conductor (8), said elongated conductor tail end inserted into said passage (25) of said interface member (10) in said longitudinal direction and terminating within a predefined range of said planar surface, wherein said tail end is fusibly joined with said electrically conductive material.

3. The electrical connector as recited in claim 2, wherein:
a) said conductive material has a melting temperature less than the melting temperature of said elongated conductor; or
b) said connector further comprising a well disposed within said interface surface of said connector body in communication with said passage such that said tail end of said elongated conductor extends within said well; or
c) said elongated conductor comprises a substantially rectangular cross-section; or
d) said elongated conductor comprises a bend of about ninety degrees; or
e) said passage comprises a substantially rectangular cross-section; or
f) said passage comprises a cross-section with an area larger than the cross-sectional area of said elongated conductor such that clearance is provided between sides of the electrical conductor and the side walls of the passage; or
g) said electrically conducting material comprises a substantially spherical shape; or
h) a portion of said connector body proximate the elongated connector tail end is coated with an anti-migration substance preferably comprising an oleophobic-hydrophobic fluoropolymer; or
i) said electrically conductive material comprises solder preferably a portion of said elongated conductor proximate said tail end is passivated to prevent solder wicking; or
j) the plurality of contacts comprise a linear array preferably
i. the plurality of contacts includes a second linear array, the second array being in stacked relation to the other array; or
ii. the connector comprises an edge card connector; or
iii. the linear array comprises two rows of contacts preferably the body includes an opening and the contacts are disposed in the opening preferably being formed in a surface of the connector body and is angled with respect to the mounting interface.

4. The electrical connector as claimed in claim 2 or 3 for use in forming an electrical connection between a contact portion of an electronic component and a contact portion of a circuit substrate, the electrical connector comprising:
a) a plurality of said electrical contacts (9) disposed on the connector body (5) and arranged to electrically mate with the contact portion of the electronic component;
b) said interface member (10) forming a mounting interface for mounting of the connector (1) on the circuit substrate, the interface member (10) located adjacent said connector body (5), having a plurality of said passages (25) therethrough, and a plurality of wells (11) disposed on said mounting interface and in communication with said passages (25);
c) a plurality of said elongated conductors (8) disposed on the connector body (5) and arranged to form an electrical connection with the circuit substrate, each elongated conductor (8) being in electrical communication with a corresponding one of said plurality of electrical contacts (9), each one of said tail ends of said plurality of elongated conductors (8), once engaging said connector body (5), is unattachedly disposed within a corresponding one of said passages (25) of said interface member (10); and
d) a plurality of solder bodies (12) constituting said second electrical contacts (12), each having a curvilinear substrate contact surface and being connected on the tail portion of a corresponding one of said elongated conductors (8) so as to form an electrical connection between said elongated conductors (8) and said contact portion of the circuit substrate.

5. The electrical connector of claim 4, wherein the solder bodies (12) are:
a) solder balls; or
b) coplanar within a range of 0.1 to 0.2 millimeters; or
c) substantially spherical in shape

6. The electrical connector as recited in claim 4, wherein said interface member (10) has a length and a width wherein said length is longer than said width and wherein said passages have a cross-section area larger than a cross-section area of said elongated conductors (8).

7. The electrical connector as recited in claim 4, wherein said elongated conductors (8) are treated such that said solder bodies (12) can attach on a single surface thereof or said elongated conductors comprise a bend.

8. The electrical connector as in claim 4, wherein the plurality of contacts comprise a first linear array.

9. The electrical connector as in claim 8, wherein:
a) the linear array comprises two rows of contacts; or
b) the plurality of contacts includes a second linear array, the second array being in stacked relation to the first array; or
c) the connector comprises an edge card connector; or
d) the body includes an opening and the contacts are disposed in the opening preferably being formed in a surface of the connector body and is angled with respect to the mounting interface.

10. The electrical connector of claim 4, wherein the wells (11) have side walls and the solder bodies (12) have a size such that said solder bodies are spaced from the side walls of the wells to provide a clearance.

11. The electrical connector as recited in claim 10, wherein said wells (11) are elongated in one direction, at least the side walls of the well in the direction of elongation being greater than the dimension of the solder body in said direction preferably the interface member is elongated and said direction of elongation of the wells is substantially parallel with the direction of elongation of said interface member.

12. The electrical connector as recited in claim 4, wherein said interface member (10) is spaced from the connector body.

13. The electrical connector as recited in claim 12, wherein:
a) said elongated conductors (8) comprise a bend located between the connector body and the interface member preferably said is about 90 degrees; or
b) at least one of a surface area of said well (11) and a surface area of said tail end other than a solder attachment surface is treated with a solder anti-migration solution, preferably comprising an oleophobic-hydrophobic fluoropolymer.

14. The electrical connector as recited in claim 1, wherein:
a) said second dielectric body (10) defines a first surface for facing a circuit substrate and said passage (25) disposed through said second dielectric body (10);
b) said tail portion of said elongated conductor (8) remains laterally moveable with respect to said second dielectric body (10); and
c) a solder body (12) constituting said fusible element (12) is fused to the end of said tail portion for being selectively faced to said circuit substrate thereby forming an electrical current path between said one end of said conductor (8) and said circuit substrate.

15. The electrical connector as claimed in claim 14, wherein said fusible element (12), or solder body (12) extends at least partially into said passage (25).

16. The electrical connector as claimed in one of the preceding claims, adapted to surface mount to a substrate, wherein
a) said passage (25) extends through a central region of said second dielectric body (10) and directly to a mounting surface;
b) said elongated conductive element (8) extending through the passage (25) has a distal end within said passage, the distal end including a side surface treated with an anti-solder migration solution and an end surface transverse to the side surface.

17. The electrical connector as recited in claim 16, wherein:
a) said solder anti-migration solution is a olephobic-hydrophobic fluoropolymer; or
b) the fusible element is a solder ball having a cross-sectional area greater than the cross-sectional area of the end surface, preferably the electrical component comprises an electrical connector.

## Patentansprüche

1. Ein elektrischer Verbinder (1) umfassend:
a) einen Leiter (8), der auf einem ersten dielektrischen Körper (5) positioniert ist, wobei der Leiter (8) ein Ausläuferende definiert;
b) einen zweiten dielektrischen Körper (10), der benachbart zu dem ersten dielektrischen Körper (5) positioniert ist, wobei der zweite dielektrischer Körper (10) eine Passage (25), die das Ausläuferende des Leiters (8) aufnimmt, definiert; und
c) ein schmelzbares Glied (12), das nur an einer Endoberfläche des Ausläuferendes des Leiters (8) durch eine Stoßverbindung angefügt ist, wobei der zweite dielektrische Körper (10) zwischen dem ersten dielektrischen Körper (5) und dem schmelzbaren Glied (12) positioniert ist.

2. Der elektrische Verbinder, wie in Anspruch 1 beansprucht, verwendet zur Ausbildung einer elektrischen Verbindung einer ersten Komponente, die einen elektrischen Kontaktabschnitt aufweist und eine zweite elektrische Komponente, die einen elektrischen Kontaktabschnitt aufweist, wobei der elektrische Verbinder umfasst:
a) einen Verbinderkörper (5), der den ersten dielektrischen Körper (5) bildet;
b) einen ersten elektrischen Kontakt (9), der innerhalb des ersten dielektrischen Körpers (5) angeordnet ist, wobei der erste elektrische Kontakt (9) eine elektrische leitfähige Oberfläche umfasst zum Verbinden mit dem elektrischen Kontaktabschnitt der ersten elektrischen Komponente, um so eine elektrische Verbindung zwischen dem ersten elektrischen Kontakt (9) und der ersten elektrischen Komponente auszubilden;
c) ein Beabstandungsglied (10), dass den zweiten dielektrischen Körper (10) bildet und einen Schacht (11) umfasst, der innerhalb einer Beabstandungsfläche des Beabstandungsglieds (10) angeordnet ist, wobei die Passage (25) den Schacht (11) mit einer zweiten Oberfläche des Beabstandungsglieds (10) verbindet;
d) ein zweiter elektrischer Kontakt (12), der das schmelzbare Glied (12) bildet und einen geformten Körper eines elektrisch leitfähigen Materials umfasst, der eine äußere Oberfläche aufweist, zur Verbindung des elektrischen Verbinders (1) mit dem elektrischen Kontaktabschnitt der zweiten elektrischen Komponente; wobei
e) der Leiter (8) länglich ist in einer longitudinalen Richtung und elektrisch verbunden ist zwischen dem ersten elektrischen Kontakt (9) und dem zweiten elektrischen Kontakt (12), wobei der Verbinderkörper (5) und das Beabstandungsglied (10) beabstandet voneinander sind entlang einer Länge des länglichen Leiters (8), wobei das Ausläuferende des länglichen Leiters in die Passage (25) des Beabstandungsglieds (10) in der longitudinalen Richtung hineingeführt ist und innerhalb eines vorbestimmten Bereichs der planeren Oberfläche endet, wobei das Ausläuferende schmelzbar verbunden ist mit dem elektrisch leitfähigen Material.

3. Der elektrische Verbinder, wie in Anspruch 2, beansprucht, wobei:
a) Das leitfähige Material eine Schmelztemperatur aufweist, die kleiner ist als die Schmelztemperatur des länglichen Leiters; oder
b) Der Verbinder weiterhin einen Schacht umfasst, der innerhalb der Beabstandungsfläche des Verbinderkörpers angeordnet ist in Kommunikation mit der Passage, so dass das Ausläuferende des länglichen Leiters sich innerhalb des Schachts erstreckt; oder
c) Der längliche Leiter umfasst einen im wesentlichen rechtwinkeligen Querschnitt; oder
d) der längliche Leiter umfasst eine Biegung von ungefähr 90°; oder
e) die Passage umfasst einen im wesentlichen rechtwinkeligen Querschnitt; oder
f) die Passage umfasst einen Querschnitt mit einem Bereich, der größer ist als der Querschnittsbereich des länglichen Leiters, so dass eine Ausnehmung zwischen Seiten des elektrischen Leiters und der Seitenwände der Passage bereitgestellt ist; oder
g) das elektrisch leitfähige Material umfasst eine im wesentlichen kugelförmige Form;
h) ein Abschnitt des Verbinderkörpers approximativ zum Ausläuferende des länglichen Leiters ist beschichtet mit einer Anti-Migrations-Substanz, die vorzugsweise ein oleophobeshydrophobes Fluorpolymer umfasst; oder
i) das elektrisch leitfähige Material umfasst Lötmittel, wobei vorzugsweise ein Abschnitt des länglichen Leiters approximativ zum Ausläuferende passiviert ist, um eine Lötmittel-Dochtwirkung zu verhindern; oder
j) die Mehrzahl der Kontakte umfasst eine lineare Anordnung vorzugsweise:
i. die Mehrzahl der Kontakte umfasst eine zweite lineare Anordnung, wobei die zweite Anordnung in gestapelter Relation zu der anderen Anordnung ist; oder
ii. der Verbinder umfasst einen Seitenkartenverbinder; oder
iii. die lineare Anordnung umfasst zwei Reihen von Kontakten, vorzugsweise umfassen die Körper eine Öffnung und die Kontakte sind angeordnet in der Öffnung, vorzugsweise in einer Oberfläche des Kontaktkörpers gebildet und ist gewinkelt bezüglich der Befestigungsschnittstelle.

4. Der elektrische Verbinder, wie in Anspruch 2 oder 3 beansprucht, verwendet zur Ausbildung einer elektrischen Verbindung zwischen einem Kontaktabschnitt einer elektronischen Komponente und einem Kontaktabschnitt eines Schaltungssubstrats, wobei der elektrische Verbinder umfasst:
a) eine Mehrzahl der elektrischen Kontakte (9), die auf dem Verbinderkörper (5) angeordnet sind und die angeordnet sind, zur elektrischen Verbindung mit den Kontaktabschnitt der elektronischen Komponente;
b) das Beabstandungsglied (10), dass eine Befestigungsschnittstelle zur Befestigung des Verbinders (1) auf dem Schaltungssubstrat ausbildet, wobei das Beabstandungsglied (10) benachbart zum Verbinderkörper (5) angeordnet ist, aufweisend eine Mehrzahl von den Passagen (25) dorthin durchgehend und eine Mehrzahl von Schächten (11), die auf der Befestigungsschnittstelle angeordnet sind und in Kommunikation mit den Passagen (25) sind;
c) eine Mehrzahl der länglichen Leiter (8), die auf dem Verbinderkörper (5) angeordnet sind und angeordnet sind, um eine elektrische Verbindung mit dem Schaltungssubstrat auszubilden, wobei jeder längliche Leiter (8) in elektrischer Kommunikation mit einem korrespondierenden elektrischen Kontakt aus der Mehrzahl der elektrischen Kontakte (9) ist, wobei jedes der Ausläuferenden eine Mehrzahl von länglichen Leitern (8) sobald diese in Eingriff stehen mit dem Verbinderkörper (5), unbefestigt angeordnet ist innerhalb einer korrespondierenden Passage (25) des Beabstandungsglieds (10); und
d) eine Mehrzahl von Lötkörpern (12), die die zweiten elektrischen Kontakte (12) bilden, wobei jeder eine gekrümmte Substratkontaktoberfläche aufweist und verbunden ist an dem Ausläuferende eines korrespondierenden länglichen Leiters (8), so dass eine elektrische Verbindung zwischen den elektrischen Leitern (8) und den Kontaktabschnitten des Schaltungssubstrats ausgebildet wird.

5. Der elektrische Verbinder aus Anspruch 4, wobei die Lötkörper (12):
a) Lötkugeln sind; oder
b) Co-planar innerhalb eines Bereichs von 0,1 bis 0,2 mm sind;
c) im Wesentlichen kugelförmig sind.

6. Der elektrische Verbinder, wie in Anspruch 4 benannt, wobei das Beabstandungsglied (10) eine Länge und eine Breite hat, wobei die Länge länger ist als die Breite und wobei die Passagen einen Querschnittsbereich aufweisen, der größer ist als ein Querschnittsbereich der länglichen Leiter (8).

7. Der elektrische Verbinder, wie in Anspruch 4 benannt, wobei die länglichen Leitern (8) so behandelt sind, dass die Lötkörper (12) an einer einzelnen Oberfläche davon angebracht werden können oder die länglichen Leiter eine Biegung umfassen.

8. Der elektrische Verbinder, wie in Anspruch 4, wobei die Mehrzahl der Kontakte eine erste lineare Anordnung umfassen.

9. Der elektrische Verbinder, wie in Anspruch 8, wobei:
a) Die lineare Anordnung umfasst zwei Reihen von Kontakten;
b) Die Mehrzahl der Kontakte umfasst eine zweite lineare Anordnung, wobei die zweite Anordnung in gestapelter Relation zu der ersten Anordnung ist; oder
c) der Verbinder umfasst einen Seitenkartenverbinder;
d) die Körper umfassen eine Öffnung und die Kontakte sind in der Öffnung angeordnet, vorzugsweise in einer Oberfläche des Verbinderkörpers und gewinkelt mit Bezug zu der Befestigungsstelle.

10. Der elektrische Verbinder aus Anspruch 4, wobei die Schächte (11) Seitenwände aufweisen und die Lötkörper (12) eine Größe aufweisen, so dass die Lötkörper beabstandet sind von den Seitenwänden der Schächte, um eine Ausnehmung bereitzustellen.

11. Der elektrische Verbinder, wie Anspruch 10 benannt, wobei die Schächte (11) in eine Richtung verlängert sind, wobei zumindest die Seitenwände der Schächte in Richtung der Verlängerung größer sind als die Ausdehnung der Lötkörper in dieser Richtung, vorzugsweise ist das Beabstandungsglied verlängert und die Richtung der Verlängerung der Schächte ist im Wesentlichen parallel mit der Richtung der Verlängerung des Beabstandungsglieds.

12. Der elektrische Verbinder, wie in Anspruch 4 benannt, wobei das Beabstandungsglied (10) beabstandet ist von dem Verbinderkörper.

13. Der elektrische Verbinder, wie in Anspruch 12 benannt, wobei:
a) die länglichen Leiter (8) eine Biegung umfassen, die angeordnet ist zwischen dem Verbinderkörper und dem Beabstandungsglied, vorzugsweise ca. 90° beträgt; oder
b) zumindest ein Oberflächenbereich des Schachts (11) und ein Oberflächenbereich des Ausläuferendes, eine andere als eine Lötbefestigungsoberfläche, sind behandelt mit einer Löt-Anti-Migrations-Substanz, wie vorzugweise ein oliophobisches-hydrophobisches-Fluorpolymer umfasst.

14. Der elektrische Verbinder, wie in Anspruch 1 benannt, wobei:
a) Der zweite dielektrische Körper (10) definiert eine erste Oberfläche gegenüberliegend eines Schaltungssubstrats und die Passage (25) ist durch den zweiten dielektrischen Körper (10) angeordnet;
b) das Ausläuferende des länglichen Leiters (8) verbleibt lateral beweglich mit Bezug zu dem zweiten dielektrischen Körper (10);
c) ein Lötkörper (12), der das schmelzbare Element (12) bildet, ist geschmolzen auf dem Ende des Ausläuferabschnitts zum selektiven Beschichten des Schaltungssubstrats, wobei dadurch ein elektrischer Strompfad zwischen dem einem Ende des Leiters (8) und dem Schaltungssubstrat gebildet wird.

15. Der elektrische Verbinder, wie in Anspruch 14 beansprucht, wobei das schmelzbare Glied (12) oder der Lötkörper (12) sich zumindest teilweise in die Passage (25) hineinerstreckt.

16. Der elektrische Verbinder, wie in einem der vorangehenden Ansprüche beansprucht, zur Oberflächenmontage auf ein Substrat, wobei
a) die Passgage (25) sich durch einen zentralen Bereich des zweiten dielektrischen Körpers (10) und direkt zu einer Montageoberfläche hinerstreckt;
b) das längliche leitfähige Glied (8) erstreckt sich durch die Passage (25) und hat ein distales Endes innerhalb der Passage, wobei das distale Ende eine Seitenoberfläche umfasst, die behandelt ist mit einem Anti-Löt-Migrations-Lösung und an einer Stirnfläche transversal zu der Seitenoberfläche behandelt ist.

17. Der elektrische Verbinder, wie in Anspruch 16 benannt, wobei:
a) Die Löt-Anti-Migrations-Lösung ein oleophobes-hydrophobes-Fluorpolymer ist;
b) das schmelzbare Glied ein Lötball ist, der einen Querschnittsbereich aufweist, der größer ist als der Querschnittsbereich der Stirnfläche, wobei vorzugsweise die elektrische Komponente einen elektrischen Verbinder umfasst.

## Revendications

1. Connecteur électrique (1) comprenant :
a) un conducteur (8) positionné sur un premier corps diélectrique (5), dans lequel le conducteur (8) définit une partie de queue ;
b) un deuxième corps diélectrique (10) positionné adjacent audit premier corps diélectrique (5), dans lequel ledit deuxième corps diélectrique (10) définit un passage (25) qui reçoit ladite partie de queue dudit conducteur (8) ; et
c) un élément fusible (12) fixé seulement sur une surface d'extrémité de ladite partie de queue dudit conducteur (8) par un joint bout à bout, dans lequel ledit deuxième corps diélectrique (10) est positionné entre ledit premier corps diélectrique (5) et ledit élément fusible (12).

2. Connecteur électrique selon la revendication 1, destiné à être utilisé lors de la formation d'une connexion électrique entre un premier élément électrique ayant une partie de contact électrique et un deuxième élément électrique ayant une partie de contact électrique, le connecteur électrique comprenant :
a) un corps de connecteur (5) constituant ledit premier corps diélectrique (5) ;
b) un premier contact électrique (9) disposé à l'intérieur dudit premier corps diélectrique (5), ledit premier contact électrique (9) comprenant une surface électriquement conductrice pour s'accoupler à la partie de contact électrique du premier élément électrique afin de former une connexion électrique entre ledit premier contact électrique (9) et le premier élément électrique ;
c) un élément d'interface (10) constituant ledit deuxième corps diélectrique (10) et comprenant une cavité (11) disposée à l'intérieur d'une surface d'interface dudit élément d'interface (10), ledit passage (25) connectant ladite cavité (11) à une deuxième surface dudit élément d'interface (10) ;
d) un deuxième contact électrique (12) constituant ledit élément fusible (12) et comprenant un corps mis en forme réalisé dans un matériau électriquement conducteur ayant une surface extérieure pour relier ledit connecteur électrique (1) à la partie de contact électrique du deuxième élément électrique ; dans lequel
e) ledit conducteur (8) étant allongé dans une direction longitudinale et connecté électriquement entre ledit premier contact électrique (9) et ledit deuxième contact électrique (12), ledit corps de connecteur (5) et ledit élément d'interface (10) étant séparés sur une longueur dudit conducteur allongé (8), l'extrémité de queue dudit conducteur allongé étant insérée dans ledit passage (25) dudit élément d'interface (10) dans ladite direction longitudinale et se terminant à une distance prédéfinie de ladite surface planaire, dans lequel ladite extrémité de queue est reliée de manière fusible audit matériau électriquement conducteur.

3. Connecteur électrique selon la revendication 2, dans lequel :
a) ledit matériau conducteur présente une température de fusion inférieure à la température de fusion dudit conducteur allongé, ou
b) ledit connecteur comprend de plus une cavité disposée à l'intérieur de ladite surface d'interface dudit corps de connecteur en communication avec ledit passage de telle sorte que ladite extrémité de queue dudit conducteur allongé s'étende à l'intérieur de ladite cavité ; ou
c) ledit conducteur allongé comprend une section transversale pour l'essentiel rectangulaire ; ou
d) ledit conducteur allongé comprend une flexion de quatre-vingt-dix degrés environ ; ou
e) ledit passage comprend une section transversale pour l'essentiel rectangulaire ; ou
f) ledit passage comprend une section transversale avec une surface plus grande que la section transversale dudit conducteur allongé de telle sorte qu'un espace existe entre les côtés du conducteur électrique et les parois latérales du passage ; ou
g) ledit matériau électriquement conducteur présente une forme pour l'essentiel sphérique ; ou
h) une partie dudit corps de connecteur proche de l'extrémité de queue du connecteur allongé est revêtu d'une substance antimigration comprenant de préférence un fluoropolymère oléophobe - hydrophobe ; ou
i) ledit matériau électriquement conducteur comprend un métal d'apport de brasage tendre, de préférence une partie dudit conducteur allongé proche de ladite extrémité de queue est passivée de manière à empêcher l'effet de mèche du métal d'apport de brasage tendre ; ou
j) la pluralité de contacts comprend une matrice linéaire de préférence
i. la pluralité de contacts inclut une deuxième matrice linéaire, la deuxième matrice se trouvant dans une relation empilée par rapport à l'autre matrice ; ou
ii. le connecteur comprend un connecteur encartable ; ou
iii. la matrice linéaire comprend deux rangées de contacts de préférence, le corps inclut une ouverture et les contacts sont disposés dans l'ouverture formée de préférence dans une surface du corps de connecteur, en faisant un angle par rapport à l'interface de montage.

4. Connecteur électrique selon l'une quelconque des revendications 2 ou 3, destiné à être utilisé lors de la formation d'une connexion électrique entre une partie de contact d'un composant électronique et une partie de contact d'un substrat de circuit, le connecteur électrique comprenant :
a) une pluralité desdits contacts électriques (9) disposés sur le corps de connecteur (5) et agencés de manière à s'accoupler électriquement à la partie de contact du composant électronique;
b) ledit élément d'interface (10) formant une interface de montage pour monter le connecteur (1) sur le substrat de circuit, l'élément d'interface (10) étant situé adjacent audit corps de connecteur (5), ayant une pluralité desdits passages (25) passant à travers, et une pluralité de cavités (11) étant disposées sur ladite interface de montage et en communication avec lesdits passages (25) ;
c) une pluralité desdits conducteurs allongés (8) étant disposés sur le corps de connecteur (5) et agencés de manière à former une connexion électrique avec le substrat de circuit, chaque conducteur allongé (8) étant en communication électrique avec l'un correspondant de ladite pluralité de contacts électriques (9), chacune desdites extrémités de queue de ladite pluralité de conducteurs allongés (8), une fois en prise avec ledit corps de connecteur (5), étant disposée de manière non fixée à l'intérieur de l'un correspondant desdits passages (25) dudit élément d'interface (10) ; et
d) une pluralité de corps de métal d'apport de brasage tendre (12) constituant lesdits deuxièmes contacts électriques (12), chacun d'eux ayant une surface de contact de substrat curviligne, et étant connecté sur la partie de queue de l'un correspondant desdits conducteurs allongés (8) afin d'établir une connexion électrique entre lesdits conducteurs allongés (8) et ladite partie de contact du substrat de circuit.

5. Connecteur électrique selon la revendication 4, dans lequel les corps de métal d'apport de brasage tendre (12) sont :
a) des boules de métal d'apport de brasage tendre ; ou
b) coplanaires à une distance comprise entre 0,1 millimètres et 0,2 millimètre ; ou
c) de forme sphérique pour l'essentiel.

6. Connecteur électrique selon la revendication 4, dans lequel ledit élément d'interface (10) présente une longueur et une largeur telles que ladite longueur est supérieure à ladite largeur, et dans lequel lesdits passages présentent une surface de section transversale supérieure à la surface de la section transversale desdits conducteurs allongés (8).

7. Connecteur électrique selon la revendication 4, dans lequel lesdits conducteurs allongés (8) sont traités de telle sorte que lesdits corps de métal d'apport de brasage tendre (12) puissent se fixer sur une seule surface de ceux-ci ou lesdits conducteurs allongés comprennent une flexion.

8. Connecteur électrique selon la revendication 4, dans lequel la pluralité de contacts comprend une première matrice linéaire.

9. Connecteur électrique selon la revendication 8, dans lequel :
a) la matrice linéaire comprend deux rangées de contacts ; ou
b) la pluralité de contacts inclut une deuxième matrice linéaire, la deuxième matrice se trouvant dans une relation empilée par rapport à la première matrice ; ou
c) le connecteur comprend un connecteur encartable ; ou
d) le corps inclut une ouverture et les contacts sont disposés dans l'ouverture formée de préférence dans une surface du corps de connecteur, en faisant un angle par rapport à l'interface de montage.

10. Connecteur électrique selon la revendication 4, dans lequel les cavités (11) ont des parois latérales et les corps de métal d'apport de brasage tendre (12) présentent une taille telle que lesdits corps de métal d'apport de brasage tendre sont espacés des parois latérales des cavités de manière à fournir un espace.

11. Connecteur électrique selon la revendication 10, dans lequel lesdites cavités (11) sont allongées dans une direction, au moins les parois latérales de la cavité dans la direction de l'allongement étant plus grandes que la dimension du corps de métal d'apport de brasage tendre dans ladite direction où est allongé de préférence l'élément d'interface, et ladite direction de l'allongement des cavités est pour l'essentiel parallèle à la direction de l'allongement dudit élément d'interface.

12. Connecteur électrique selon la revendication 4, dans lequel ledit élément d'interface (10) est espacé du corps de connecteur.

13. Connecteur électrique selon la revendication 12, dans lequel :
a) lesdits conducteurs allongés (8) comprennent une flexion située entre le corps de connecteur et l'élément d'interface, ladite flexion étant de préférence de 90 degrés environ ; ou
b) au moins l'une d'une surface de ladite cavité (11) et d'une surface de ladite extrémité de queue différente d'une surface de fixation de métal d'apport de brasage tendre, est traitée avec une solution antimigration de métal d'apport de brasage tendre, comprenant de préférence un fluoropolymère oléophobe - hydrophobe.

14. Connecteur électrique selon la revendication 1, dans lequel:
a) ledit deuxième corps diélectrique (10) définit une première surface pour faire face à un substrat de circuit et à un dit passage (25) disposé à travers ledit deuxième corps diélectrique (10) ;
b) ladite partie de queue dudit conducteur allongé (8) reste mobile de manière latérale par rapport audit deuxième corps diélectrique (10) ; et
c) un corps de métal d'apport de brasage tendre (12) constituant ledit élément fusible (12) est fixé par fusion à l'extrémité de ladite partie de queue pour faire face de manière sélective audit substrat de circuit, en formant de ce fait un chemin de passage de courant électrique entre une dite extrémité dudit conducteur (8) et ledit substrat de circuit.

15. Connecteur électrique selon la revendication 14, dans lequel ledit élément fusible (12), ou ledit corps de métal d'apport de brasage tendre (12) s'étend au moins en partie dans ledit passage (25).

16. Connecteur électrique selon l'une quelconque des revendications précédentes, adapté à un montage en surface sur un substrat, dans lequel :
a) ledit passage (25) s'étend à travers une région centrale dudit deuxième corps diélectrique (10) et directement vers une surface de montage ;
b) ledit élément conducteur allongé (8) qui s'étend à travers le passage (25) a une extrémité distale située à l'intérieur dudit passage, l'extrémité distale comprenant une surface latérale traitée avec une solution antimigration du métal d'apport de brasage tendre et une surface d'extrémité transversale à la surface latérale.

17. Connecteur électrique selon la revendication 16, dans lequel :
a) ladite solution antimigration du métal d'apport de brasage tendre est un fluoropolymère oléophobe - hydrophobe ; ou
b) l'élément fusible est une boule de métal d'apport de brasage tendre qui présente une surface de section transversale supérieure à la surface de section transversale de la surface d'extrémité, de préférence le composant électrique comprend un connecteur électrique.
